# EUROPÄISCHE PATENTANMELDUNG

(11) **EP 1 375 128 A2**
(43) Veröffentlichungstag der Anmeldung: **02.01.2004**
(21) Anmeldenummer: 03013814.3
(22) Anmeldetag: 18.06.2003
(51) Int. Cl.: B32B 3/24, B32B 15/08, H05K 1/03

(54) **Verfahren zur Herstellung eines flächenhaften Metall-Kunststoff-Folienverbundes sowie danach hergestelltes Substrat**

(30) Priorität: 21.06.2002 DE 10227937
(71) Anmelder: W.C. Heraeus GmbH & Co. KG, 63450 Hanau (DE)
(72) Erfinder: Hartmann, Horst, 63454 Hanau (DE); Kolodzei, Günter, 63791 Karlstein (DE); Bauer, Alfred, 63755 Alzenau-Albstadt (DE); Rabe, Michael, 63486 Bruchköbel (DE)
(74) Vertreter: Kühn, Hans-Christian

(57) **Zusammenfassung**

Die Erfindung betrifft ein Verfahren zur Herstellung eines flächenhaften Metall-Kunststoff-Folienverbundes als Substrat zur Aufnahme elektrischer oder elektronischer Bauelemente oder elektrisch leitender Strukturen, wobei der Metall-Kunststoff-Folienverbund aus mindestens einer Metallfolie mit Ausnehmungen und aus einer elektrisch isolierenden Kunststoffschicht gebildet ist, die mindestens eine Schicht aus wärmeaktivierbarem Kunststoffkleber umfasst, wobei die mindestens eine Metallfolie mit der Kunststoffschicht zu dem Metall-Kunststoff-Folienverbund laminiert wird. Die Metallfolie wird derart in die Schicht aus Kunststoffkleber eingebettet, dass der Kunststoffkleber die Ausnehmungen in der Metallfolie zumindest teilweise füllt und die dem Kunststoffkleber abgewandte Oberfläche der Metallfolie frei von Kunststoffkleber verbleibt. Die Erfindung betrifft weiterhin ein nach diesem Verfahren hergestelltes Substrat.

## Beschreibung

Die Erfindung betrifft ein Verfahren zur Herstellung eines flächenhaften Metall-Kunststoff-Folienverbundes als Substrat zur Aufnahme elektrischer oder elektronischer Bauelemente oder elektrisch leitender Strukturen, wobei der Metall-Kunststoff-Folienverbund aus mindestens einer Metallfolie mit Ausnehmungen und aus einer elektrisch isolierenden Kunststoffschicht gebildet ist, die mindestens eine Schicht aus wärmeaktivierbarem Kunststoffkleber umfasst, wobei die mindestens eine Metallfolie mit der Kunststoffschicht zu dem Metall-Kunststoff-Folienverbund laminiert wird. Die Erfindung betrifft weiterhin ein nach diesem Verfahren hergestelltes Substrat.

Elektrische oder elektronische Bauelemente werden mittels Löten, Schweißen, Bonden oder Kleben auf das Substrat aufgebracht.

Die an Stelle von elektrischen oder elektronischen Bauelementen aufzubringenden elektrisch leitenden Strukturen werden z.B. durch Drucken, Sputtern oder Aufdampfen aufgebracht. Solche Strukturen können beispielsweise auf ein Leitungselement als Schmelzsicherung gerichtet sein.

Ein gattungsgemäßes Verfahren ist aus der DE 199 51 164 A1 bekannt. Hier wird ein Folienverbund aus mindestens zwei strukturierten Folienbahnen durch Laminieren erzeugt. Die Herstellung des Folienverbundes erfolgt beispielsweise durch Laminieren einer strukturierten Metallfolie mit einer strukturierten Transferfolie, die aus einer Trägerfolie und einer Heißkleber-Folie zusammengesetzt ist.

Die DE 44 11 618 A1 oder die DE 195 21 022 A1 offenbaren ein Verfahren zur Herstellung eines Schichtverbundes aus mindestens zwei gestanzten Folienbahnen, die identische Positionsmarkierungen zum passgenauen Laminieren der Folienbahnen aufweisen.

Weiterhin ist aus der EP 0 823 098 B1 bzw. der entsprechenden US 6,066,231 eine Vorrichtung zur Klebstoffverbindung eines Metallbandes mit einem Band aus Isolierstoff bekannt, wobei ein etwa 35 mm breiter Metallstreifen aus Kupfer oder Bronze als metallischer Teil und eine Folie aus Polyimid als elektrisch isolierender Teil des Metallkunststoffverbundes eingesetzt wird.

Als problematisch erweisen sich solchermaßen laminierte Metallkunststoffverbunde hinsichtlich ihres Schichtenaufbaus, da sich diese bei starker mechanischer Beanspruchung gegeneinander verschieben können bzw. brechen können.

Weiterhin ist es verhältnismäßig aufwendig, auf den elektrisch isolierenden Teil des Metallkunststoffverbundes Leiterstrukturen z.B. als Widerstands- oder Sicherungselemente aufzubringen.

Aus der US 5,059,262 ist ein Verfahren zur Herstellung von Folienmaterial zur Bildung von elektrischen Verbindungen mit eng beabstandeten Anschlusspunkten bekannt, die als elektrische Verbindung zwischen elektronischen Komponenten dient. Dabei wird unter anderem ein mehrschichtiger Aufbau aus einer elektrisch isolierenden Substratfolie aus Kunststoff und einer Kunststoffkleberschicht offenbart, in welche einzelne, langgestreckte Metalladern nebeneinander ganz oder teilweise eingebettet werden. Die Metalladern werden gebildet, indem flüssiges Metall über eine Kapillare oder Nadel linienförmig auf einen Träger aufgebracht und abgekühlt wird. Dadurch wird eine Metallader mit nahezu rundem Querschnitt erzeugt, wobei jedoch im Kontaktbereich zum Träger eine Abflachung an der Metallader ausgebildet wird. Es handelt sich dabei um ein verhältnismäßig aufwendiges Verfahren.

Aufgabe der Erfindung ist es, ein einfaches Verfahren zur Herstellung eines Metall-Kunststoff-Folienverbundes bereitzustellen, mit welchem mechanisch stabilere Substrate zur einfachen und mechanisch festen Aufbringung von elektrischen bzw. elektronischen Bauelementen oder elektrisch leitenden Strukturen hergestellt werden können.

Die Aufgabe wird für das Verfahren dadurch gelöst, dass die mindestens eine Metallfolie derart in die Schicht aus Kunststoffkleber eingebettet wird, dass der Kunststoffkleber die Ausnehmungen in der Metallfolie zumindest teilweise füllt und die dem Kunststoffkleber abgewandte Oberfläche der Metallfolie frei von Kunststoffkleber verbleibt.

Als Werkstoff für die Metallfolie sind Kupfer bzw. eine Kupferbasislegierung besonders geeignet. Als besonders vorteilhaft hat sich eine Kupfer-Zinn-Legierung mit einem Kupferanteil von 94 Gewichts-% sowie einem Zinnanteil von 6 Gewichts-% erwiesen. Metallfolien mit einer Dicke im Bereich von 0,01 mm bis 1 mm haben sich bewährt.

Die bevorzugte Dicke der Kunststoffschicht liegt im Bereich von 0,02 mm bis 1,5 mm.

Die Dicke einer Schicht aus wärmeaktivierbarem Kunststoffkleber liegt vorzugsweise im Bereich von 0,01 bis 0,2 mm, wobei die Schicht aus Kunststoffkleber über eine Transferfolie gemäß der DE 199 51 164 A1, die üblicherweise eine Dicke im Bereich von 0,02 bis 0,2 mm aufweist, eingebracht werden kann.

Das Laminieren erfolgt vorteilhafterweise unter einem Druck von 1,5 bis 3 bar und bei einer Temperatur im Bereich von ca. 120 bis 180°C. Die Dicke des so erstellten Metall-Kunststoff-Folienverbundes liegt vorzugsweise im Bereich von 0,05 mm bis 3 mm.

Als besonders vorteilhaft erweist sich die verhältnismäßig einfache Herstellung des Metall-Kunststoff-Folienverbundes. Durch die gebildete Verzahnung zwischen Metallfolie und der Schicht aus Kunststoffkleber im Bereich der Ausnehmungen in der Metallfolie wird ein mechanisch stabilerer Verbund ausgebildet, als das bei den bisher bekannten Folienverbunden der Fall war, die eine derartige Verzahnung nicht vorsahen. Dabei erweist sich die Möglichkeit der Miniaturisierung von Komponenten zur dichten Bestückung des Metall-Kunststoff-Folienverbundes als besonders vorteilhaft.

Vorteilhafte Ausgestaltungen des Verfahrens sind in den Ansprüchen 2 bis 16 angegeben.

Als besonders vorteilhaft hat es sich erwiesen, wenn die Metallfolie aus einem Metallband mit mindestens einem perforierten Randstreifen zum Bandtransport gebildet wird, in welches erste Ausnehmungen gestanzt sind. Die Perforierung zum Bandtransport kann aber auch in einem anderen Bereich des Metallbandes verlaufen, beispielsweise in der Mitte.

Weiterhin hat es sich als vorteilhaft erwiesen, wenn die elektrisch isolierende Kunststoffschicht als Kunststoffband mit mindestens einem perforierten Randstreifen zum Bandtransport ausgebildet ist, in welches zweite Ausnehmungen gestanzt sind. Die Perforierung zum Bandtransport kann aber auch in einem anderen Bereich des Kunststoffbandes verlaufen, beispielsweise in der Mitte. Dabei ist darauf zu achten, dass die Perforierungen im Metallband und im Kunststoffband einander entsprechen, so dass beim Laminieren eine durchgehende Perforierung gebildet wird, in welche eine Transportführung greifen kann und ein ungestörter Weitertransport des Laminats ermöglicht wird.

Vorzugsweise entsprechen die zweiten Ausnehmungen im Kunststoffband den ersten Ausnehmungen im Metallband zumindest teilweise. Das bedeutet, dass nach dem Laminieren im Substrat durchgehende Öffnungen verbleiben.

Bewährt hat sich ein Verfahren, bei welchem eine erste Metallfolie mit einer elektrisch isolierenden Kunststoffschicht laminiert wird, die lediglich aus einer ersten Schicht aus wärmeaktivierbarem Kunststoffkleber gebildet ist. Die bevorzugte Dicke der Schicht aus Kunststoffkleber beträgt 0,01 mm bis 0,2 mm. Dabei kann die Dicke der Schicht aus Kunststoffkleber so gewählt sein, dass nur die Ausnehmungen in der ersten Metallfolie mit Kunststoffkleber gefüllt werden und die Ober- und Unterseite der Metallfolie frei bleiben. Somit ist eine elektrische Kontaktierung der ersten Metallfolie im Metall-Kunststoff-Folienverbund sowohl von unten als von oben möglich. Die Dicke der Schicht aus Kunststoffkleber kann aber auch so gewählt sein, dass die der Schicht aus Kunststoffkleber zugewandte Oberfläche der ersten Metallfolie mit Kunststoffkleber bedeckt bleibt. Dann ist eine elektrische Kontaktierung der ersten Metallfolie im Metall-Kunststoff-Folienverbund ohne weiteres nur von oben möglich. Ein nachträgliches Freilegen von bedeckten Bereichen der Metallfolie zur elektrischen Kontaktierung ist natürlich immer möglich.

Bewährt hat sich weiterhin ein Verfahren, bei welchem auf der der ersten Metallfolie abgewandten Seite der ersten Schicht aus wärmeaktivierbarem Kunststoffkleber eine zweite Metallfolie laminiert wird. Diese kann als Trägerfolie fungieren und dabei ohne Ausnehmungen gestaltet sein.
Aber auch eine zweite Metallfolie mit Ausnehmungen ist anwendbar, wobei die erste und die zweite Metallfolie auch in elektrischen Kontakt gebracht werden können. Somit ist eine elektrische Kontaktierung der ersten Metallfolie im Metall-Kunststoff-Folienverbund sowohl von oben als auch von unten über die zweite Metallfolie als möglich. Wird kein Kontakt zwischen der ersten und der zweiten Metallfolie ausgebildet, so können beide auf ihrer der Schicht aus Kunststoffkleber abgewandten Oberfläche elektrisch kontaktiert werden. Auf diese Weise ist eine raumsparende Bestückung zu beiden Seiten des Metall-Kunststoff-Folienverbundes mit elektrischen oder elektronischen Bauelementen möglich.

Bewährt hat sich außerdem ein Verfahren, bei welchem auf der der ersten Metallfolie abgewandten Seite der ersten Schicht aus wärmeaktivierbarem Kunststoffkleber eine zweite Schicht aus wärmeaktivierbarem Kunststoffkleber laminiert wird, die auf der der ersten Schicht aus wärmeaktivierbarem Kunststoffkleber abgewandten Seite eine zweite Metallfolie aufweist. Diese kann wieder als Trägerfolie fungieren und dabei ohne Ausnehmungen gestaltet sein.
Aber auch eine zweite Metallfolie mit Ausnehmungen ist anwendbar, wobei die erste und die zweite Metallfolie auch in elektrischen Kontakt gebracht werden können. Somit ist eine elektrische Kontaktierung der ersten Metallfolie im Metall-Kunststoff-Folienverbund sowohl von oben als auch von unten über die zweite Metallfolie als möglich. Wird kein Kontakt zwischen der ersten und der zweiten Metallfolie ausgebildet, so können beide auf ihrer der Schicht aus Kunststoffkleber abgewandten Oberfläche elektrisch kontaktiert werden. Auf diese Weise ist eine raumsparende Bestückung zu beiden Seiten des Metall-Kunststoff-Folienverbundes mit elektrischen oder elektronischen Bauelementen möglich.

Vorzugsweise wird eine erste Metallfolie mit einer elektrisch isolierenden Kunststoffschicht laminiert, die aus einer ersten Schicht aus wärmeaktivierbarem Kunststoffkleber und einer Kunststofffolie gebildet ist. Die Kunststofffolie besteht dabei vorzugsweise als Polyacryl. Es ist jedoch auch möglich eine Kunststofffolie aus Epoxidharz, bzw. glasfaserverstärktem Epoxid, Polyamid und PEN (Polyethylennaphtenat) einzusetzen. Die Dicke einer Kunststofffolie beträgt vorzugsweise 0,02 mm bis 1,5 mm. Auf diese Weise lässt sich eine besonders gute Stabilität des Metall-Kunststoff-Folienverbundes erzielen.

Dabei hat es sich bewährt, wenn die Kunststofffolie auf ihrer der ersten Schicht aus wärmeaktivierbarem Kunststoffkleber abgewandten Seite mit einer zweiten Schicht aus wärmeaktivierbarem Kunststoffkleber verbunden wird, wobei die zweite Schicht aus wärmeaktivierbarem Kunststoffkleber mit einer zweiten Metallfolie verbunden wird. Diese kann wieder als Trägerfolie fungieren und dabei ohne Ausnehmungen gestaltet sein. Aber auch eine zweite Metallfolie mit Ausnehmungen ist anwendbar. Da dabei kein Kontakt zwischen der ersten und der zweiten Metallfolie ausgebildet wird, können beide auf ihrer der Schicht aus Kunststoffkleber abgewandten Oberfläche elektrisch kontaktiert werden. Auf diese Weise ist eine raumsparende Bestückung zu beiden Seiten des Metall-Kunststoff-Folienverbundes mit elektrischen oder elektronischen Bauelementen möglich.

In einer bevorzugten Ausgestaltung der Erfindung wird die Metallfolie lediglich so weit in die Schicht aus Kunststoffkleber eingebettet, dass der Kunststoffkleber die Ausnehmungen in der Metallfolie nur teilweise füllt. Die Metallfolie ragt demnach aus der Schicht aus Kunststoffkleber heraus, so dass besonders vorteilhaft eine leichte Zugänglichkeit der Metallfolie für die Aufbringung von elektrischen oder elektronischen Bauelementen oder elektrisch leitenden Strukturen erreicht wird.

In einer weiteren bevorzugten Ausgestaltung der Erfindung wird die Metallfolie so weit in die Schicht aus Kunststoffkleber eingebettet, dass der Kunststoffkleber die Ausnehmungen in der Metallfolie vollständig füllt. Die der Schicht aus Kunststoffkleber abgewandte Oberfläche der Metallfolie schließt demnach bündig mit dem Kunststoffkleber ab, so dass die Oberfläche des Metall-Kunststoff-Folienverbundes eben ausgebildet ist. Hierbei erweist sich die gebildete ebene Fläche für die Aufbringung von pastenförmigen Bauteilen (Siebdruck) oder beispielsweise einer Widerstandsbeschichtung bzw. eines Sicherungsstreifens als Überlastungsschutz als besonders vorteilhaft.

Vorzugsweise entsprechen die zweiten Ausnehmungen im Kunststorfband den ersten Ausnehmungen im Metallband nur teilweise, so dass nach dem Laminieren Teile des Metallbandes von der elektrisch isolierenden Kunststoffschicht frei bleiben und Öffnungen im Metall-Kunststoff-Folienverbund verbleiben. Zu den Öffnungen benachbarte, frei gebliebene Teile des Metallbandes werden als Metallfahnen zur späteren Kontaktierung von elektrischen oder elektronischen Bauteilen derart gebogen, dass die Metallfahnen sich aus der Ebene des Metallbandes erheben.

Dabei hat es sich bewährt, wenn wenigstens zwei Metallfahnen gebildet werden, die sich - in Richtung des Bandtransportes gesehen -gegenüber liegen und eine von der elektrisch isolierenden Kunststoffschicht gebildete Oberfläche zwischen sich einschließen. Die Metallfahnen bilden an der Unterseite des Substrates sozusagen Kontaktbeinchen für eine elektrische Kontaktierung von Bauelementen, die auf der Oberseite des Substrates angebracht werden.

Vorzugsweise werden die Metallfahnen derart ein zweites Mal gebogen, so dass sie jeweils einen Rand der elektrisch isolierenden Kunststoffschicht im Bereich der zweiten Ausnehmungen u-förmig umschließen. Die Metallfahnen bilden an der Unterseite des Substrates Kontaktflächen für eine elektrische Kontaktierung von Bauelementen, die auf der Oberseite des Substrates angebracht werden.

Es hat sich bewährt, wenn zwischen wenigstens zwei Metallfahnen eine Leiterbahn aus elektrisch leitender Paste auf die von der elektrisch isolierenden Kunststoffschicht gebildete Oberfläche aufgebracht wird, wobei die Leiterbahn mit den Metallfahnen elektrisch und mechanisch fest verbunden wird. Eine solche Leiterbahn aus Paste lässt sich beispielsweise als Messwiderstand für Temperaturen oder auch Schmelzsicherung (Legierung mit verhältnismäßig niedrigem Schmelzpunkt) gegen elektrische Überlastung einsetzen.

Wenigstens ein elektrisches und/oder elektronisches Bauelement kann dann mit seinen Kontakten auf den Metall-Kunststoff-Folienverbund aufgebracht und elektrisch und mechanisch fest mit den Metallfahnen verbunden werden.

Besonders bewährt hat es sich dabei, wenn wenigstens ein Bauelement als SMD-Bauteil auf den Metall-Kunststoff-Folienverbund aufgebracht wird und mit u-förmig gebogenen Metallfahnen elektrisch und mechanisch fest verbunden wird.

Nach der Herstellung eines bandförmigen Metall-Kunststoff-Folienverbundes werden Substrate vorzugsweise dadurch gebildet, dass eine gewünschte Leiterbahnstruktur herausgetrennt wird. Dies kann beispielsweise durch Schneiden oder Stanzen erfolgen, wobei die Schnitte derart gesetzt werden, dass im Hinblick auf die Metallfolie(n) mit Ausnehmungen Bereiche ganz oder teilweise aufgetrennt und so eine Leiterbahnstruktur ausgebildet wird. Es ist in einfacher Weise möglich, eine Vielzahl unterschiedlicher Bauelemente vor oder nach einer solchen Vereinzelung aufzubringen und diese in einfacher Weise mit dem Substrat zu verbinden.

Ein nach dem erfindungsgemäßen Verfahren gebildetes Substrat ist für die Aufnahme von elektrischen oder elektronischen Bauelementen optimal geeignet. Dabei wird vorzugsweise ein Bauelement mit wenigstens zwei sich gegenüberliegenden Kontaktflächen mit den Metallfahnen elektrisch und mechanisch fest verbunden.

Im Hinblick auf die Miniaturisierung eines solchen Substrats ist es bevorzugt, wenn ein SMD-Bauelement mit u-förmig gebogenen Metallfahnen elektrisch und mechanisch fest verbunden ist.
Ein nach dem Verfahren hergestellter Metall-Kunststoff-Folienverbund findet vorteilhafterweise Verwendung als Substrat. Dabei wird es als Halbleiterträger, IC-Gehäuseteil, laminierter Konnektor, Träger einer aufpastierten Schicht ( beispielsweise Widerstand, Sensor oder Schmelzsicherungselement bzw. Überlastschutz) oder als Verbinder nach dem Flip-Chip-Prinzip eingesetzt.

Nachfolgend wird der Gegenstand der Erfindung anhand der Figuren 1 bis 8b beispielhaft erläutert. So zeigt
- Figur 1: eine perspektivische Darstellung einer ersten Metallfolie mit Ausnehmungen, die auf eine Schicht aus wärmeaktivierbarem Kunststoffkleber auf einer Trägerfolie aufgebracht werden soll.
- Figur 1a: den gemäß Figur 1 gebildeten Metall-Kunststoff-Folienverbund, auf dessen Oberfläche ein Bauelement aufgebracht ist.
- Figur 2: eine perspektivische Darstellung einer ersten Metallfolie mit Ausnehmungen, die auf eine Schicht aus wärmeaktivierbarem Kunststoffkleber aufgebracht werden soll.
- Figur 2a: den gemäß Figur 2 gebildeten Metall-Kunststoff-Folienverbund, auf dessen Oberfläche ein Bauelement aufgebracht ist.
- Figur 2b: eine perspektivische Darstellung einer ersten Metallfolie mit ersten Ausnehmungen und einer zweiten Metallfolie mit zweiten Ausnehmungen, die auf die Seiten einer Schicht aus wärmeaktivierbarem Kunststoffkleber aufgebracht werden sollen.
- Figur 2c: den gemäß Figur 2b gebildeten Metall-Kunststoff-Folienverbund, auf dessen Oberfläche ein Bauelement aufgebracht ist.
- Figur 3: eine doppelseitige Ausführungsform eines Metall-Kunststoff-Folienverbundes.
- Figur 4: eine vereinfachte Ausführungsform eines Metall-Kunststoff-Folienverbundes, wobei in die Ober- und die Unterseite einer Schicht aus Kunststoffkleber jeweils eine Metallfolie mit Ausnehmungen eingebettet ist.
- Figur 5a: eine Draufsicht auf eine Metallfolie mit Ausnehmungen, die als Metallband ausgestaltet ist.
- Figur 5b: das Metallband aus Figur 5a im Längsschnitt entlang der Linie AA.
- Figur 6a: eine Draufsicht auf einen Metall-Kunststoff-Folienverbund.
- Figur 6b: einen möglichen Längsschnitt des Metall-Kunststoff-Folienverbundes aus Figur 6a entlang der Linie BB, wobei lediglich eine Schicht aus wärmeaktivierbarem Kunststoffkleber als elektrisch isolierende Kunststoffschicht vorhanden ist.
- Figur 6c: einen weiteren möglichen Längsschnitt des Metall-Kunststoff-Folienverbundes aus Figur 6a entlang der Linie BB, wobei eine elektrisch isolierende Kunststoffschicht aus einer Schicht wärmeaktivierbarem Kunststoffkleber und einer Kunststofffolie vorgesehen ist
- Figur 7a: einen Metall-Kunststoff-Folienverbund mit einer Schicht aus Kunststoffkleber, wobei Metallfahnen umgebogen und Bauelemente aufmontiert sind.
- Figur 7b: einen möglichen Längsschnitt des Metall-Kunststoff-Folienverbundes aus Figur 7a entlang der Linie CC, wobei zwei sich gegenüber liegende, einfach umgebogene Metallfahnen, welche die dazwischen liegende Oberfläche des Kunststoffklebers eingrenzen. Es sind bereits aufmontierte Bauelemente sichtbar.
- Figur 7c: einen weiteren möglichen Längsschnitt des Metall-Kunststoff-Folienverbundes aus Figur 7a entlang der Linie CC mit jeweils zwei sich gegenüber liegenden, u-förmig gebogenen Metallfahnen, welche die dazwischen liegende Oberfläche des Kunststoffklebers eingrenzen. Es sind bereits aufmontierte Bauelemente sichtbar.
- Figur 7d: analog zu Figur 7b einfach umgebogene Metallfahnen, wobei ein Metall-Kunststoff-Folienverbund mit Kunststofffolie und einer Schicht wärmeaktivierbarem Kunststoffkleber eingesetzt wird.
- Figur 7e: analog zu Figur 7c u-förmig gebogene Metallfahnen, wobei ein Metall-Kunststoff-Folienverbund mit Kunststofffolie und einer Schicht wärmeaktivierbarem Kunststoffkleber eingesetzt wird.
- Figur 8a: zeigt in perspektivischer Ansicht einen Ausschnitt aus einem bandförmigen Metall-Kunststoff-Folienverbund, der bereits mit elektrischen oder elektronischen Bauelementen bestückt ist.
- Figur 8b: eine Vergrößerung des Bereiches B in Figur 8a.

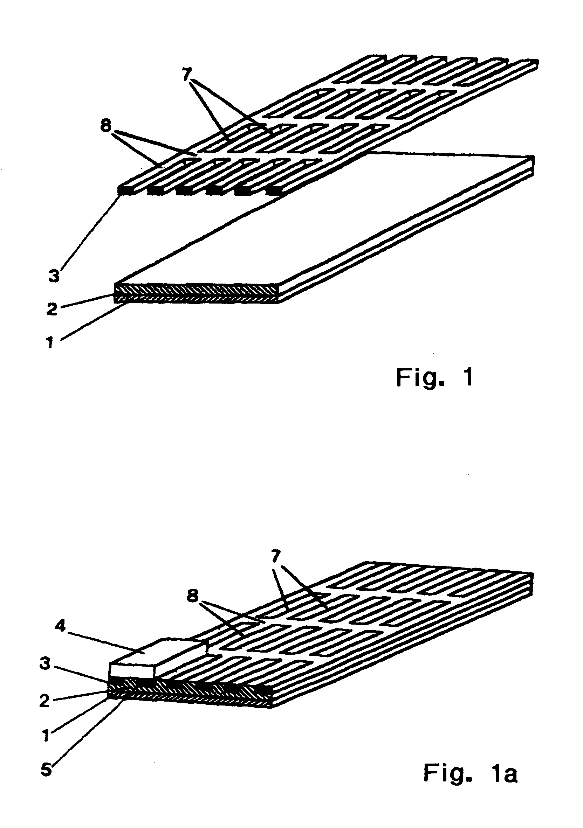

Gemäß Figur 1 ist auf einer Trägerfolie 1 aus Metall oder Kunststoff eine Schicht aus Kunststoffkleber 2 aufgebracht, die als Folie aus wärmeaktivierbarem Kunststoffkleber mit einer definierten Dicke im Bereich von 0,010 bis 0,2 mm ausgebildet ist. Auf die Schicht aus Kunststoffkleber 2 wird eine Metallfolie 3 auflaminiert (siehe Figur 1a), die in regelmäßigen Abständen angeordnete Ausnehmungen 7 aufweist. Die Metallfolie 3 wird in die Schicht aus Kunststoffkleber 2 derart eingebettet, dass die Oberfläche der Metallfolie 3, welche der Schicht aus Kunststoffkleber 2 abgewandt ist, frei von Kunststoffkleber verbleibt. In dieser Ausführungsform werden die Ausnehmungen 7 vollständig mit Kunststoffkleber gefüllt (siehe Figur 1a). Die die Ausnehmungen 7 umgebenden Stege 8 der Metallfolie 3 bilden Leiterpfade für die Aufbringung von elektrischen bzw. elektronischen Bauelementen, wobei zur Herstellung von Leitungsmustern bestimmte Stege 8 entfemt bzw. elektrisch voneinander isoliert werden.

Figur 1a zeigt die bereits in die Schicht aus Kunststoffkleber 2 gemäß Figur 1 einlaminierte Metallfolie 3, wobei sich im Eingangsbereich ein elektronisches Bauelement 4 befindet, welches mit seinen hier nicht sichtbaren Gehäusekontakten mit Kontaktbereichen 5 der Stege 8 mit der Metallfolie 3 verbunden ist. Die vom elektronischen Bauteil 4 abgedeckten Bereiche der Stege 8 weisen bereits eine Strukturierung in Form von elektrischen Leitpfaden auf, welche für den jeweiligen Anwendungsfall vorgegeben sind.

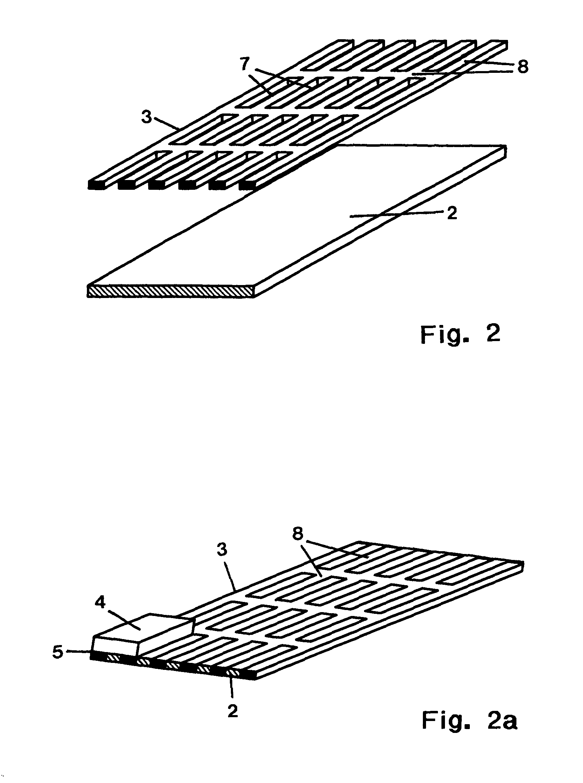

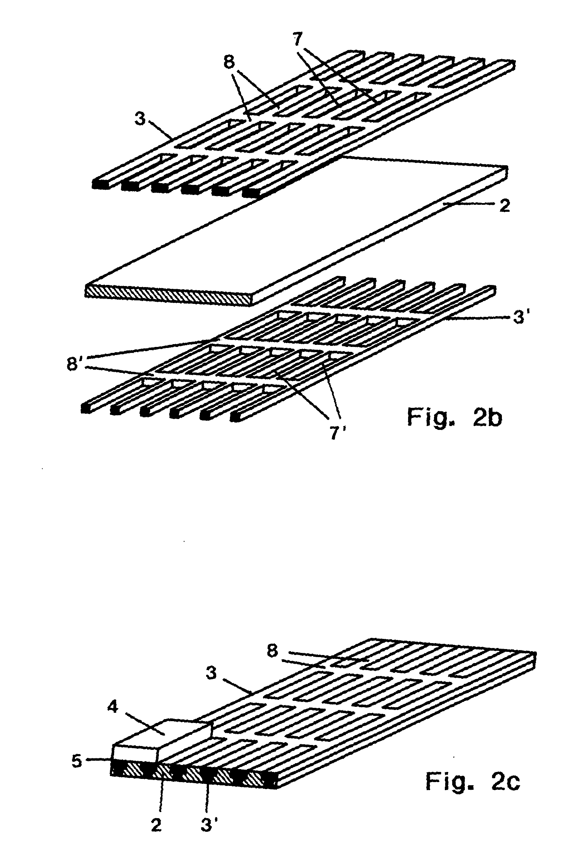

Figur 2 zeigt eine Schicht aus Kunststoffkleber 2, die als Folie aus wärmeaktivierbarem Kunststoffkleber ausgebildet ist. Auf die Schicht aus Kunststoffkleber 2 wird eine Metallfolie 3 auflaminiert (siehe Figur 2a), die in regelmäßigen Abständen angeordnete Ausnehmungen 7 aufweist. Die Metallfolie 3 wird in die Schicht aus Kunststoffkleber 2 derart eingebettet, dass die Oberfläche der Metallfolie 3, welche der Schicht aus Kunststoffkleber 2 abgewandt ist, frei von Kunststoffkleber verbleibt. In dieser Ausführungsform werden die Ausnehmungen 7 vollständig mit Kunststoffkleber gefüllt (siehe Figur 2a) und die Ober- und Unterseite der Metallfolie 3 ist nach dem Laminieren frei von Kunststoffkleber. Die die Ausnehmungen 7 umgebenden Stege 8 der Metallfolie 3 bilden Leiterpfade für die Aufbringung von elektrischen bzw. elektronischen Bauelementen, wobei zur Herstellung von Leitungsmustem bestimmte Stege 8 entfernt bzw. elektrisch voneinander isoliert werden.

Figur 2a zeigt die bereits in die Schicht aus Kunststoffkleber 2 gemäß Figur 2 einlaminierte Metallfolie 3, wobei sich im Eingangsbereich ein elektronisches Bauelement 4 befindet, welches mit seinen hier nicht sichtbaren Gehäusekontakten mit Kontaktbereichen 5 der Stege 8 mit der Metallfolie 3 verbunden ist. Die vom elektronischen Bauteil 4 abgedeckten Bereiche der Stege 8 weisen bereits eine Strukturierung in Form von elektrischen Leitpfaden auf, welche für den jeweiligen Anwendungsfall vorgegeben sind.

Figur 2b zeigt eine Schicht aus Kunststoffkleber 2, die als Folie aus wärmeaktivierbarem Kunststoffkleber ausgebildet ist. Auf die Oberseite der Schicht aus Kunststoffkleber 2 wird eine Metallfolie 3 auflaminiert (siehe Figur 2c), die in regelmäßigen Abständen angeordnete Ausnehmungen 7 aufweist. Die Metallfolie 3 wird in die Schicht aus Kunststoffkleber 2 derart eingebettet, dass die Oberfläche der Metallfolie 3, welche der Schicht aus Kunststoffkleber 2 abgewandt ist, frei von Kunststoffkleber verbleibt. Auf die Unterseite der Schicht aus Kunststoffkleber 2 wird eine Metallfolie 3' auflaminiert (siehe Figur 2c), die in regelmäßigen Abständen angeordnete Ausnehmungen 7' aufweist. Die Metallfolie 3' wird in die Schicht aus Kunststoffkleber 2 derart eingebettet, dass die Oberfläche der Metallfolie 3', welche der Schicht aus Kunststoffkleber 2 abgewandt ist, frei von Kunststoffkleber verbleibt. Außerdem werden die erste Metallfolie 3 und die zweite Metallfolie 3' beim Laminieren miteinander in Kontakt gebracht, so dass eine elektrisch leitfähige Verbindung entsteht. In dieser Ausführungsform werden die Ausnehmungen 7, 7' vollständig mit Kunststoffkleber gefüllt (siehe Figur 2c). Die die Ausnehmungen 7 umgebenden Stege 8 der Metallfolie 3 bilden Leiterpfade für die Aufbringung von elektrischen bzw. elektronischen Bauelementen, wobei zur Herstellung von Leitungsmustern bestimmte Stege 8 entfernt bzw. elektrisch voneinander isoliert werden. Die elektrische Kontaktierung der montierten Bauelemente erfolgt dann über die zweite Metallfolie 3'.

Figur 2c zeigt die bereits in die Schicht aus Kunststoffkleber 2 gemäß Figur 2b einlaminierten Metallfolien 3, 3', wobei sich im Eingangsbereich ein elektronisches Bauelement 4 befindet, welches mit seinen hier nicht sichtbaren Gehäusekontakten mit Kontaktbereichen 5 der Stege 8 mit der Metallfolie 3 verbunden ist. Die vom elektronischen Bauteil 4 abgedeckten Bereiche der Stege 8 weisen bereits eine Strukturierung in Form von elektrischen Leitpfaden auf, welche für den jeweiligen Anwendungsfall vorgegeben sind.

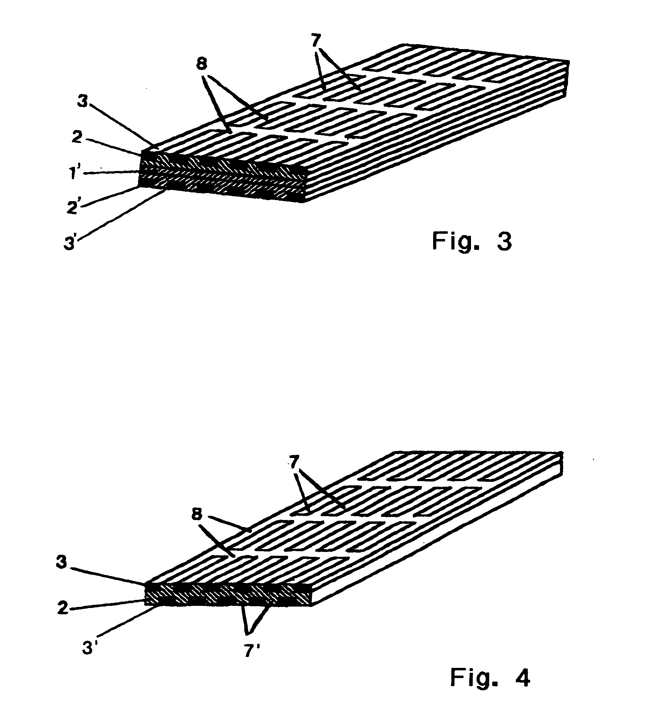

Figur 3 zeigt einen Metall-Kunststoff-Folienverbund ähnlich wie er anhand der Figuren 1 und 1a erläutert ist, wobei jedoch die Unterseite der Trägerfolie 1 mit einer zweiten Schicht aus Kunststoffkleber 2' versehen ist, in die eine zweite Metallfolie 3' mit Ausnehmungen 7' eingebettet ist. Dabei sind die Ausnehmungen 7' in der zweiten Metallfolie 3' vollständig mit Kunststoffkleber gefüllt.

In Figur 4 ist ein Metall-Kunststoff-Folienverbund dargestellt, bei dem keine Trägerfolie 1 vorhanden ist, so dass sowohl die Ober- als auch die Unterseite der Schicht aus Kunststoffkleber 2 jeweils mit einer darin eingebetteten Metallfolie 3, 3', die jeweils Ausnehmungen 7, 7' aufweisen, versehen sind.

Die Dicke der Schicht aus Kunststoffkleber 2 ist dabei so gewählt, dass sich die eingebetteten Metallfolien 3, 3' auf den sich jeweils gegenüberliegenden Seiten nicht berühren. Somit ist ein beidseitiges Bestücken oder ein nachträgliches Verbinden der Metallfolien 3, 3' möglich.

Figur 4 stellt einen Metall-Kunststoff-Folienverbund mit verhältnismäßig einfachem Aufbau dar und ist damit eine preisgünstige Alternative zu den Anordnungen gemäß den Figuren 1, 1a und 3.

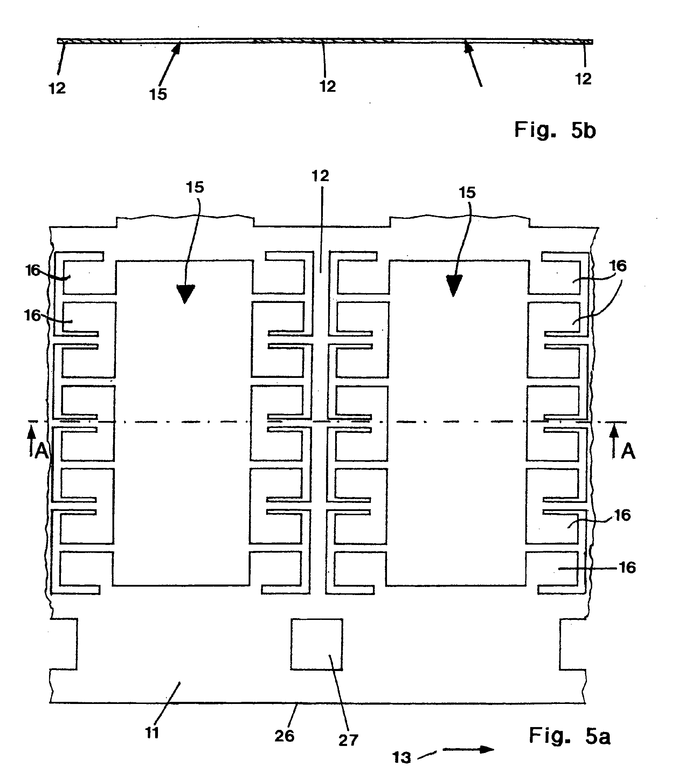

Figur 5a zeigt einen Ausschnitt eines Metallbandes 11 in Draufsicht, das mit gestanzten Ausnehmungen 15 versehen ist. Am unteren Rand des Metallbandes 11 ist ein Randstreifen 26 zu erkennen, der eine zur Führung und zum Bandtransport dienende Perforation 27 aufweist. Ein diesem Randstreifen 26 gegebenenfalls gegenüber liegender Randstreifen ist nicht dargestellt. Senkrecht zur Transportrichtung 13 des Metallbandes 11 sind Stege 12 voneinander beabstandet angeordnet. Die Breite des Metallbandes beträgt vorzugsweise 35 mm (Kinofilm-Format); es ist jedoch auch möglich, ein Metallband der Breite von 70 mm einzusetzen. Dabei ist es möglich, zwischen den Randstreifen mehrere in Transportrichtung 13 gesehen nebeneinander angeordnete Stege 12 vorzusehen. Die Stege 12 weisen eine Vielzahl von umklappbaren Laschen 16 auf, die nach Erstellung des Metall-Kunststoff-Folienverbundes zu Metallfahnen umgebogen werden, so dass sie nach Aufbringung von Bauelementen und nachfolgender Vereinzelung als Kontakte für eine elektrische und mechanisch feste Verbindung - beispielsweise durch eine Schmelzverbindung (Löten, Schweißen) - auf einer Leiterplatte dienen können.
Anhand des Längsschnitts AA aus Figur 5a ist in Figur 5b das Metallband 11 inklusive der Ausnehmungen 15 zu erkennen.

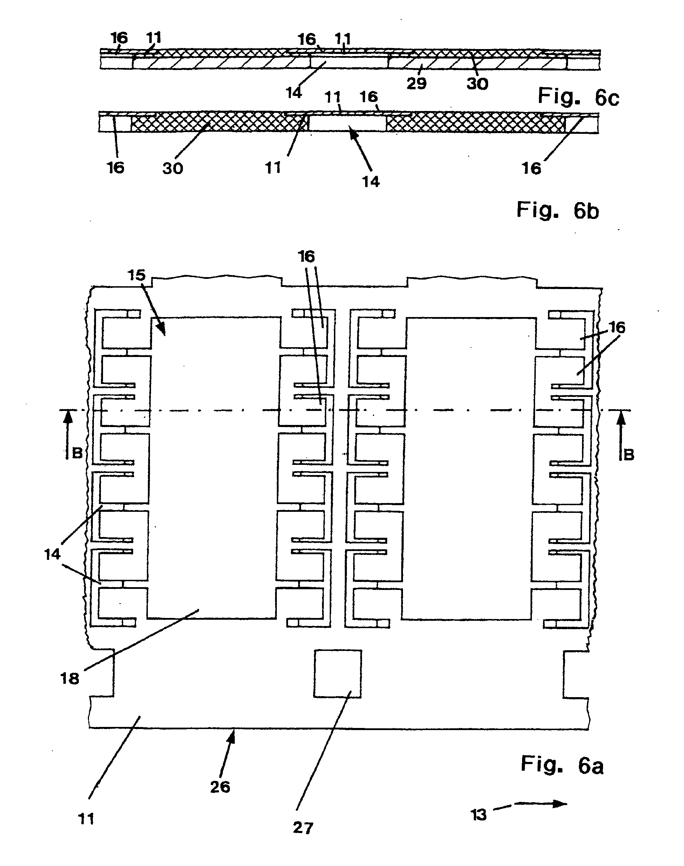

Figur 6a zeigt in einer Draufsicht einen Metall-Kunststoff-Folienverbund aus dem Metallband 11 aus Figuren 5a, 5b und einem Kunststoffband 18. Das Kunststoffband 18 weist Ausnehmungen 14 auf, die den Ausnehmungen 15 des Metallbandes 11 nur teilweise entsprechen. Dabei liegen die Ausnehmungen 14 so, dass den Metalllaschen 16 Raum für die Umbiegung zu Metallfahnen verbleibt. Das Kunststoffband 18 weist ebenfalls Randstreifen mit einer Perforation zur sicheren Führung entlang der Transportrichtung 13 auf, wobei die Perforation 27 in den Randstreifen von Metallband 11 und Kunststoffbarid 18 sich überdecken.

Gemäß dem Längsschnitt BB aus Figur 6a ist in Figur 6b ein möglicher Metall-Kunststoff-Folienverbund erkennbar, wobei als Kunststoffband 18 lediglich eine Schicht aus wärmeaktivierbarem Kunststoffkleber 30 vorhanden ist. Die Ausnehmungen 15 im Metallband 11 sind nunmehr mit dem Kunststoffkleber gefüllt, während die Metalllaschen 16 noch seitlich abstehen, d.h. noch nicht umgebogen sind.

Gemäß dem Längsschnitt BB aus Figur 6a ist in Figur 6c ein weiterer möglicher Metall-Kunststoff-Folienverbund gezeigt, bei dem das Kunststoffband 18 aus einer Schicht wärmeaktivierbarem Kunststoffkleber 30 auf einer Kunststofffolie 29 gebildet ist. Die Ausnehmungen 15 im Metallband 11 sind nunmehr mit dem Kunststoffkleber gefüllt, während die Metalllaschen 16 noch seitlich abstehen, d.h. noch nicht umgebogen sind.

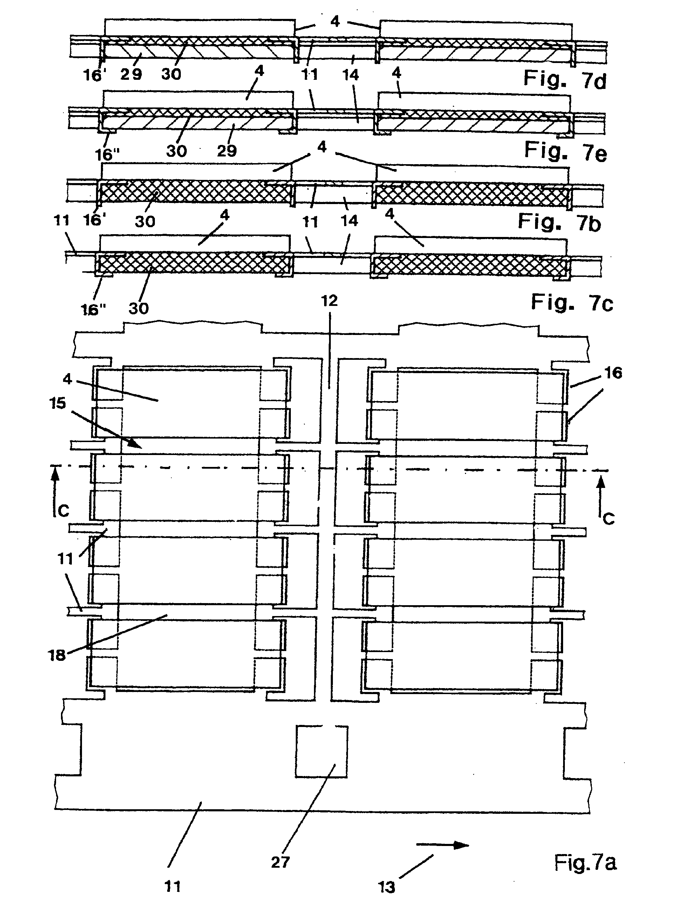

Figur 7a zeigt in der Draufsicht das Metallband 11 mit aufmontierten Bauelementen 4 (mit vier Kontaktstellen). Darunter befindet sich das Kunststoffband 18, welches hier lediglich noch ausschnittsweise durch die Ausnehmungen 15 im Metallband 11 erkennbar ist. Nachdem im Laminierungsprozess das Metallband 11 in die Schicht aus Kunststoffkleber 30 des Kunststoffbandes 18 eingebettet ist, werden die Metalllaschen 16 senkrecht nach unten zu Metallfahnen 16', 16" gebogen, wie dies anhand der Figuren 7b bis 7d erkennbar ist. Auf diese Weise lässt sich ein verhältnismäßig stabiler Metall-Kunststoff-Folienverbund erzielen. Die Metallfahnen 16', 16" füngieren quasi als Kontaktbeinchen oder Kontaktflächen zum elektrischen Kontaktieren der Bauelemente 4 von der Unterseite des Metall-Kunststoff-Folienverbundes aus.

Figur 7b zeigt einen möglichen Längsschnitt CC aus Figur 7a. Dabei ist die Schicht aus Kunststoffkleber 30 mit den Ausnehmungen 14 zu erkennen, in welche das Metallband 11 eingebettet ist. Weiterhin sind die Metallfahnen 16', die als Kontaktbeinchen durch die Ausnehmungen 14 ragen, und die auf dem Metallband 11 montierten Bauelemente 4 zu erkennen.

Figur 7c zeigt einen weiteren möglichen Längsschnitt CC aus Figur 7a. Dabei ist die Schicht aus Kunststoffkleber 30 mit den Ausnehmungen 14 zu erkennen, in welche das Metallband 11 eingebettet ist. Weiterhin sind die Metallfahnen 16", die u-förmig die Schicht aus Kunststoffkleber 30 umgeben, und die auf dem Metallband 11 montierten Bauelemente 4 zu erkennen. Auf diese Weise ist eine besonders gute Stabilität des Metall-Kunststoff-Folienverbundes auch bei komplizierter Bestückung zu erzielen.

Figur 7d zeigt einen weiteren möglichen Längsschnitt CC aus Figur 7a. Dabei ist die Schicht aus Kunststoffkleber 30 auf einer Kunststofffolie 29 zu erkennen. Weiterhin sind die Ausnehmungen 14 in der Schicht aus Kunststoffkleber 30 und der Kunststofffolie 29 zu erkennen. Das Metallband 11 ist in die Schicht aus Kunststoffkleber 30 eingebettet. Weiterhin sind die Metallfahnen 16', die als Kontaktbeinchen durch die Ausnehmungen 14 ragen, und die auf dem Metallband 11 montierten Bauelemente 4 zu erkennen.

Figur 7e zeigt einen weiteren möglichen Längsschnitt CC aus Figur 7a. Dabei ist die Schicht aus Kunststoffkleber 30 auf einer Kunststofffolie 29 zu erkennen. Weiterhin sind die Ausnehmungen 14 in der Schicht aus Kunststoffkleber 30 und der Kunststofffolie 29 zu erkennen. Das Metallband 11 ist in die Schicht aus Kunststoffkleber 30 eingebettet. Weiterhin sind die Metallfahnen 16", die u-förmig die Schicht aus Kunststoffkleber 30 und die Kunststofffolie 29 umgeben, und die auf dem Metallband 11 montierten Bauelemente 4 zu erkennen.

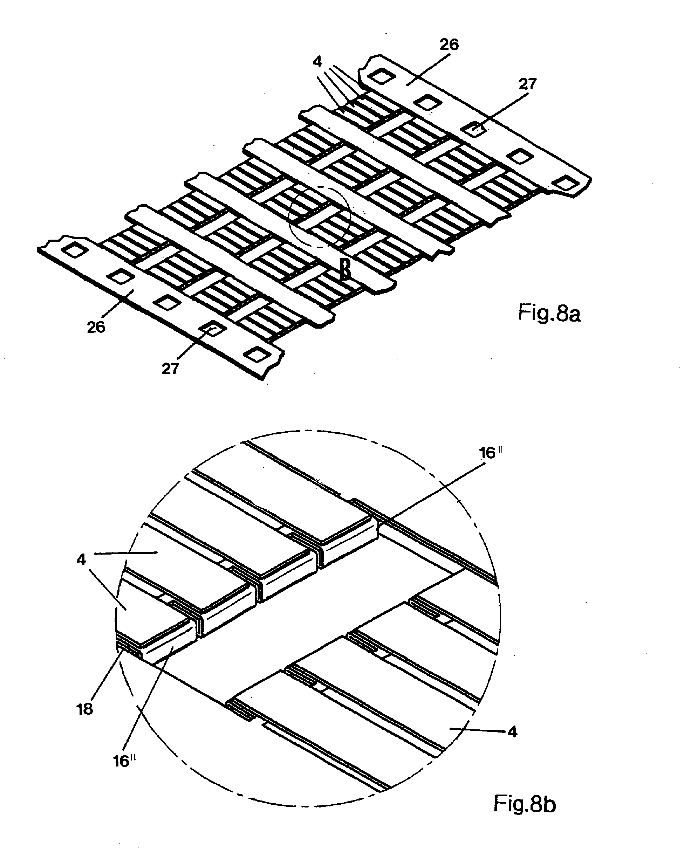

In Figur 8a ist ein Ausschnitt aus einem bandförmigen Metall-Kunststoff-Folienverbund zu erkennen, der an seinen Seiten jeweils mit einem Randstreifen 26 mit Perforation 27 zum Bandtransport versehen ist. Auf den Metall-Kunststoff-Folienverbund sind Bauelemente 4 aufgebracht, wie es bereits anhand der Figuren 7a bis 7e erläutert worden ist. Die jeweiligen Bauelemente 4 sind auf der Metallfolie aufgebracht, wobei die Verbindung von Bauelementen 4 und Metall-Kunststoff-Folienverbund anhand der Vergrößerung des Bereiches B in Figur 8b erkennbar ist. Die aufgesetzten Bauelemente 4 sind mit dem oberen Teil der Metallfahnen 16" durch eine Schmelzverbindung - wie z.B. Löten oder Schweißen - elektrisch und mechanisch verbunden, wobei an den jeweiligen Seitenbereich des Metall-Kunststoff-Folienverbundes noch das Kunststoffband 18 erkennbar ist. Die Metallfahnen 16" sind u-förmig nach unten umgebogen, so dass an der Unterseite des Metall-Kunststoff-Folienverbundes metallische Kontaktflächen für die elektrische Verbindung der vereinzelten Bauelemente zur Aufbringung auf Leiterplatten geschaffen werden.

## Patentansprüche

1. Verfahren zur Herstellung eines flächenhaften Metall-Kunststoff-Folienverbundes als Substrat zur Aufnahme elektrischer oder elektronischer Bauelemente oder elektrisch leitender Strukturen, wobei der Metall-Kunststoff-Folienverbund aus mindestens einer Metallfolie mit Ausnehmungen und aus einer elektrisch isolierenden Kunststoffschicht gebildet ist, die mindestens eine Schicht aus wärmeaktivierbarem Kunststoffkleber umfasst, wobei die mindestens eine Metallfolie mit der Kunststoffschicht zu dem Metall-Kunststoff-Folienverbund laminiert wird, **dadurch gekennzeichnet, dass** die mindestens eine Metallfolie (3, 3') derart in die Schicht aus Kunststoffkleber (2, 2') eingebettet wird, dass der Kunststoffkleber die Ausnehmungen (7, 7') in der Metallfolie (3, 3') zumindest teilweise füllt und die dem Kunststoffkleber abgewandte Oberfläche der Metallfolie (3, 3') frei von Kunststoffkleber verbleibt.

2. Verfahren nach Anspruch 1, **dadurch gekennzeichnet, dass** die Metallfolie (3, 3') aus einem Metallband (11) mit mindestens einem perforierten Randstreifen (26) zum Bandtransport gebildet wird, in welches erste Ausnehmungen (15) gestanzt sind.

3. Verfahren nach Anspruch 2, **dadurch gekennzeichnet, dass** die elektrisch isolierende Kunststoffschicht als Kunststoffband (18) mit mindestens einem perforierten Randstreifen zum Bandtransport ausgebildet ist, in welches zweite Ausnehmungen (14) gestanzt sind.

4. Verfahren nach Anspruch 3, **dadurch gekennzeichnet, dass** die zweiten Ausnehmungen (14) im Kunststoffband (18) den ersten Ausnehmungen (15) im Metallband (11) zumindest teilweise entsprechen.

5. Verfahren nach einem der Ansprüche 1 bis 4, **dadurch gekennzeichnet, dass** eine erste Metallfolie (3) mit einer elektrisch isolierenden Kunststoffschicht laminiert wird, die lediglich aus einer ersten Schicht aus wärmeaktivierbarem Kunststoffkleber (2) gebildet ist.

6. Verfahren nach Anspruch 5, **dadurch gekennzeichnet, dass** auf der der ersten Metallfolie (3) abgewandten Seite der ersten Schicht aus wärmeaktivierbarem Kunststoffkleber (2) eine zweite Metallfolie (3') laminiert wird.

7. Verfahren nach Anspruch 5, **dadurch gekennzeichnet, dass** auf der der ersten Metallfolie (3) abgewandten Seite der ersten Schicht aus wärmeaktivierbarem Kunststoffkleber (2) eine zweite Schicht aus wärmeaktivierbarem Kunststoffkleber laminiert wird, die auf der der ersten Schicht aus wärmeaktivierbarem Kunststoffkleber abgewandten Seite eine zweite Metallfolie aufweist.

8. Verfahren nach einem der Ansprüche 1 bis 4, **dadurch gekennzeichnet, dass** eine erste Metallfolie (3) mit einer elektrisch isolierenden Kunststoffschicht laminiert wird, die aus einer ersten Schicht aus wärmeaktivierbarem Kunststoffkleber (2) und einer Kunststofffolie (1') gebildet ist.

9. Verfahren nach Anspruch 8, **dadurch gekennzeichnet, dass** die Kunststofffolie (1') auf ihrer der ersten Schicht aus wärmeaktivierbarem Kunststoffkleber (2) abgewandten Seite mit einer zweiten Schicht aus wärmeaktivierbarem Kunststoffkleber (2') verbunden wird, wobei die zweite Schicht aus wärmeaktivierbarem Kunststoffkleber (2') mit einer zweiten Metallfolie (3') verbunden wird.

10. Verfahren nach einem der Ansprüche 1 bis 9, **dadurch gekennzeichnet, dass** die Metallfolie (3, 3') lediglich so weit in die Schicht aus Kunststoffkleber (2, 2') eingebettet wird, dass der Kunststoffkleber die Ausnehmungen in der Metallfolie (3, 3') nur teilweise füllt.

11. Verfahren nach einem der Ansprüche 1 bis 9, **dadurch gekennzeichnet, dass** die Metallfolie (3, 3') so weit in die Schicht aus Kunststoffkleber (2, 2') eingebettet wird, dass der Kunststoffkleber die Ausnehmungen in der Metallfolie (3, 3') vollständig füllt.

12. Verfahren nach Anspruch 4 oder nach Anspruch 4 in Verbindung mit einem der Ansprüche 5 bis 11, **dadurch gekennzeichnet, dass** die zweiten Ausnehmungen (14) im Kunststoffband (18) den ersten Ausnehmungen (15) im Metallband (11) nur teilweise entsprechen, so dass nach dem Laminieren Teile des Metallbandes (11) von der elektrisch isolierenden Kunststoffschicht frei bleiben und Öffnungen im Metall-Kunststoff-Folienverbund verbleiben, und dass zu den Öffnungen benachbarte, frei gebliebene Teile des Metallbandes (11) als Metallfahnen (16', 16") derart gebogen werden, dass die Metallfahnen (16', 16") sich aus der Ebene des Metallbandes (11) erheben.

13. Verfahren nach Anspruch 12, **dadurch gekennzeichnet, dass** wenigstens zwei Metallfahnen (16', 16") gebildet werden, die sich - in Richtung des Bandtransportes (13) gesehen - gegenüber liegen und eine von der elektrisch isolierenden Kunststoffschicht gebildete Oberfläche einschließen.

14. Verfahren nach einem der Ansprüche 12 bis 13, **dadurch gekennzeichnet, dass** die Metallfahnen (16') derart ein zweites Mal gebogen werden, so dass sie jeweils einen Rand der elektrisch isolierenden Kunststoffschicht im Bereich der zweiten Ausnehmungen (14) u-förmig umschließen.

15. Verfahren nach einem der Ansprüche 13 bis 14, **dadurch gekennzeichnet, dass** zwischen wenigstens zwei Metallfahnen (16', 16") eine Leiterbahn aus elektrisch leitender Paste auf die von der elektrisch isolierenden Kunststoffschicht gebildete Oberfläche aufgebracht wird, wobei die Leiterbahn mit den Metallfahnen (16', 16") elektrisch und mechanisch fest verbunden wird.

16. Verfahren nach einem der Ansprüche 12 bis 15, **dadurch gekennzeichnet, dass** wenigstens ein elektrisches und/oder elektronisches Bauelement (4) mit seinen Kontakten auf den Metall-Kunststoff-Folienverbund aufgebracht und elektrisch und mechanisch fest mit den Metallfahnen (16', 16") verbunden wird.

17. Verfahren nach Anspruch 16, **dadurch gekennzeichnet, dass** wenigstens ein Bauelement (4) als SMD-Bauteil auf den Metall-Kunststoff-Folienverbund aufgebracht wird und mit u-förmig gebogenen Metallfahnen (16") elektrisch und mechanisch fest verbunden wird.

18. Substrat für die Aufnahme von elektrischen oder elektronischen Bauelementen, das nach einem Verfahren gemäß einem der Ansprüche 12 bis 17 hergestellt worden ist, **dadurch gekennzeichnet, dass** ein Bauelement (4) mit wenigstens zwei sich gegenüberliegenden Kontaktflächen mit den Metallfahnen (16', 16") elektrisch und mechanisch fest verbunden ist.

19. Substrat nach Anspruch 18, **dadurch gekennzeichnet, dass** ein SMD-Bauelement mit u-förmig gebogenen Metallfahnen (16") elektrisch und mechanisch fest verbunden ist.
